# EUROPÄISCHE PATENTSCHRIFT

(11) **EP 4 283 646 B1**
(45) Veröffentlichungstag und Bekanntmachung des Hinweises auf die Patenterteilung: **01.01.2025**
(21) Anmeldenummer: 23175459.9
(22) Anmeldetag: 25.05.2023
(51) Int. Cl.: H01H 21/24, H01H 19/03, H03K 17/97

(54) **BETÄTIGUNGSVORRICHTUNG FÜR EINEN DREHSCHALTER MIT AUTOMATISCHER RÜCKSETZUNG**
ACTUATING DEVICE FOR ROTARY SWITCH WITH AUTOMATIC RESET
DISPOSITIF D'ACTIONNEMENT POUR UN INTERRUPTEUR ROTATIF À RÉINITIALISATION AUTOMATIQUE

(30) Priorität: 26.05.2022 CN 202221286167 U
(43) Veröffentlichungstag der Anmeldung: 29.11.2023
(73) Patentinhaber: Oceanwell (Xiamen) Industrial Co., Ltd., Xiamen, Fujian (CN)
(72) Erfinder: ZHANG, Junhua, Haicang Dist., Xiamen (CN); PENG, Dong, Haicang Dist., Xiamen (CN)
(74) Vertreter: Rätsch, Caroline

(56) Entgegenhaltungen:
- CN-U- 212 990 973
- DE-A1- 102019 126 145
- GB-A- 1 225 768

## Beschreibung

### Technisches Gebiet

Die vorliegende Erfindung betrifft eine Betätigungsvorrichtung insbesondere für einen Drehschalter mit automatischer Rücksetzung zur Verwendung an einer Toilette.

### Stand der Technik

Übliche Betätigungsvorrichtungen für handbetätigte Drehschalter mit Rücksetzung verwenden Drehknöpfe zur Steuerung, wobei manche Drehknöpfe keine automatische Rücksetzungsfunktion aufweisen. Bei manchen Drehknöpfen wird durch das Zusammenwirken mit einem Magneten oder einer Feder eine automatische Rücksetzungsfunktion realisiert. Die Lösung mit der automatischen Rücksetzung durch einen Magneten ist von der Konstruktion her kompliziert und bedingt hohe Kosten. Bei einer Verwendung zum Auslösen einer Hall-Komponente treten leicht Störungen auf. Bei der Lösung der automatischen Rücksetzung durch eine Feder ist die Montage der Feder nicht einfach. Auch beeinträchtigt der erhebliche Platzbedarf der Feder die Anordnung der sonstigen Teile. Somit sind die Betätigungsvorrichtungen für einen Drehschalter mit automatischer Rücksetzung nach dem Stand der Technik nicht ausreichend einfach.

Aus der GB 1 225 768 A ist eine Betätigungsvorrichtung für einen Drehschalter mit automatischer Rücksetzung bekannt, die einen Griff, eine Montageachse und zwei Federn aufweist, wobei ein Ende des Griffs eine Durchgangsöffnung zum Umgreifen der Montageachse aufweist, wobei der vorstehend bezeichnete Griff in Umfangsrichtung um die Montageachse drehbar ist, wobei zwischen dem Griff und der Montageachse zwei in Umfangsrichtung verlaufende bogenförmige Rillen angeordnet sind, wobei die beiden Federn jeweils in den beiden bogenförmigen Rillen montiert sind, wobei die Federn zwischen der Montageachse und dem Griff eingespannt sind, und wobei der Griff bei einer Vorwärtsdrehung um die vorstehend bezeichnete Montageachse die eine Feder komprimiert, während der Griff bei einer Rückwärtsdrehung um die Montageachse die andere Feder komprimiert.

### Inhalt der Erfindung

Die vorliegende Erfindung stellt eine Betätigungsvorrichtung für einen Drehschalter mit automatischer Rücksetzung zur Verfügung, umfassend einen Griff, eine Montageachse und zwei Federn, wobei ein Ende des vorstehend bezeichneten Griffs eine Durchgangsöffnung zum Umgreifen der vorstehend bezeichneten Montageachse aufweist, wobei der vorstehend bezeichnete Griff in Umfangsrichtung um die vorstehend bezeichnete Montageachse drehbar ist, wobei zwischen dem vorstehend bezeichneten Griff und der Montageachse zwei in Umfangsrichtung verlaufende bogenförmige Rillen angeordnet sind, wobei die beiden vorstehend bezeichneten Federn jeweils in den beiden vorstehend bezeichneten bogenförmigen Rillen montiert sind, wobei die vorstehend bezeichneten Federn zwischen der vorstehend bezeichneten Montageachse und dem Griff eingespannt sind, und wobei der vorstehend bezeichnete Griff bei einer Vorwärtsdrehung um die vorstehend bezeichnete Montageachse die eine Feder komprimiert, während der vorstehend bezeichnete Griff bei einer Rückwärtsdrehung um die vorstehend bezeichnete Montageachse die andere Feder komprimiert. Konkret ist vorgesehen, dass der vorstehend bezeichnete Griff im Verlauf der Vorwärtsdrehung aus der Anfangsposition die eine Feder allmählich komprimiert, so dass durch die Vorwärtsdrehung des Griffs eine entsprechende Funktion gestartet werden kann. Nach dem Loslassen des vorstehend bezeichneten Griffs erfolgt gleichzeitig mit der automatischen Entspannung der komprimierten Feder ein Drücken des vorstehend bezeichneten Griffs zur Rückwärtsdrehung in die Anfangsposition. Im Verlauf der Rückwärtsdrehung des vorstehend bezeichneten Griffs aus der Anfangsposition wird die andere Feder allmählich komprimiert wird, wobei die entsprechende Funktion auch durch die Vorwärtsdrehung des Griffs gestartet werden kann. Nach dem Loslassen des vorstehend bezeichneten Griffs erfolgt gleichzeitig mit der automatischen Entspannung der komprimierten Feder ein Drücken des vorstehend bezeichneten Griffs zur Vorwärtsdrehung in die Anfangsposition.

Zwischen dem Griff und der Montageachse sind bogenförmige Rillen zur Montage der Federn vorgesehen, wobei gleichzeitig mit der Drehung des Griffs die eine Feder komprimiert wird und die Feder nach der Komprimierung Energie speichert. Sobald der Griff losgelassen wird, wird die Rücksetzung durchgeführt, indem gleichzeitig mit der Freisetzung der Energie der Feder ein Drücken des Griffs zur Drehung in der Gegenrichtung erfolgt, was bedeutet, dass die Federn den Griff zur automatischen Rücksetzung in die Anfangsposition antreiben können. Somit ist die erfindungsgemäße Lösung äußerst einfach und kompakt, ebenso wie die Montage der Federn sehr einfach ist.

Bei einer vorteilhaften beispielhaften Ausführungsform ist vorgesehen, dass die beiden vorstehend bezeichneten bogenförmigen Rillen in einem Radialschnitt auf demselben Umfang angeordnet sind. Somit ist der Druck der Federn bei Vorwärtsdrehung und Rückwärtsdrehung des Griffs gleichmäßig und übereinstimmend, was zu einem besseren haptischen Empfinden bei der Betätigung führt.

Bei einer vorteilhaften beispielhaften Ausführungsform ist vorgesehen, dass es sich bei den vorstehend bezeichneten Federn um gebogene Federn oder um gerade Federn handelt. Falls gebogene Federn verwendet werden, ist die Form der Federn ähnlich zu den bogenförmigen Rillen, was die Drehung des Griffs erleichtert.

Bei einer vorteilhaften beispielhaften Ausführungsform ist vorgesehen, dass zwischen dem vorstehend bezeichneten Griff und der vorstehend bezeichneten Montageachse eine Begrenzungseinrichtung vorgesehen ist, welche die Vorwärtsdrehung und die Rückwärtsdrehung des vorstehend bezeichneten Griffs begrenzt. Auf diese Weise kann das Auftreten einer Fehlbetätigung vermieden werden.

Bei einer vorteilhaften beispielhaften Ausführungsform ist vorgesehen, dass die vorstehend bezeichnete Begrenzungseinrichtung einen an dem vorstehend bezeichneten Griff vorgesehenen Vorsprung sowie eine an der vorstehend bezeichneten Montageachse vorgesehene Begrenzungsaussparung umfasst. Dadurch, dass der Vorsprung jeweils an die Wände der beiden Enden der Begrenzungsaussparung stößt, erfolgt eine Begrenzung der Vorwärtsdrehung und der Rückwärtsdrehung erfolgen, was eine einfache Konstruktion darstellt.

Bei einer vorteilhaften beispielhaften Ausführungsform ist ferner eine Positionierungsabdeckung umfasst, wobei die vorstehend bezeichnete Positionierungsabdeckung die vorstehend bezeichnete Montageachse umgreift, und wobei die vorstehend bezeichnete Positionierungsabdeckung an einem axialen Ende des vorstehend bezeichneten Griffs angeordnet und durch Klemmen mit dem vorstehend bezeichneten Griff verbunden ist.

Bei einer vorteilhaften beispielhaften Ausführungsform ist vorgesehen, dass die vorstehend bezeichnete Positionierungsabdeckung mit der vorstehend bezeichneten Montageachse axial durch Klemmen verbunden ist. Die Positionierungsabdeckung ist nicht nur mit dem Griff, sondern auch mit der Montageachse durch Klemmen verbunden, so dass eine axiale Position des Griffs an der Montageachse definiert ist und eine axiale Verschiebung des Griffs vermieden wird.

Bei einer vorteilhaften beispielhaften Ausführungsform ist vorgesehen, dass außerdem eine drehbare Abdeckung umfasst ist, wobei die vorstehend bezeichnete drehbare Abdeckung und die vorstehend bezeichnete Positionierungsabdeckung jeweils an einem Ende des vorstehend bezeichneten Griffs befindlich sind, und wobei die vorstehend bezeichnete drehbare Abdeckung axial das Ende der vorstehend bezeichneten Montageachse abdeckt und sich bis zur Stirnfläche der anderen Seite des vorstehend bezeichneten Griffs erstreckt. Die drehbare Abdeckung und die Positionierungsabdeckung decken die Seiten des Griffs von zwei Seiten ab, was die Kompaktheit des Produkts verbessert.

Bei einer vorteilhaften beispielhaften Ausführungsform ist vorgesehen, dass mittig der Platine ein sich axial auf die vorstehend bezeichnete drehbare Abdeckung hin erstreckender Einstellstift vorgesehen ist, wobei der vorstehend bezeichnete Einstellstift durch Stecken mit der vorstehend bezeichneten drehbaren Abdeckung verbunden ist, wobei die vorstehend bezeichnete drehbare Abdeckung in Umfangsrichtung mit dem vorstehend bezeichneten Einstellstift in Klemmverbindung steht, und wobei der vorstehend bezeichnete Einstellstift bezogen auf die vorstehend bezeichnete Platine drehbar ist.

Die drehbare Abdeckung kann den Einstellstift zur Drehung mitbewegen, so dass die entsprechende Einstellfunktion realisiert werden kann (durch Drehung des Einstellstifts kann eine Einstellung der Platinen-Parameter vorgenommen werden).

Bei einer vorteilhaften beispielhaften Ausführungsform ist ferner eine Befestigungsabdeckung umfasst, wobei die vorstehend bezeichnete Platine innerhalb der vorstehend bezeichnete Montageachse angeordnet ist, wobei die vorstehend bezeichnete Befestigungsabdeckung innerhalb der vorstehend bezeichneten drehbaren Abdeckung aufgenommen und außerhalb der vorstehend bezeichneten Montageachse angeordnet ist, wobei sich der vorstehend bezeichnete Einstellstift axial aus der vorstehend bezeichneten Montageachse herauserstreckt, und wobei die vorstehend bezeichnete Befestigungsabdeckung mit dem vorstehend bezeichneten Einstellstift in Gewindeeingriff steht. Durch die Schraubverbindung der Befestigungsabdeckung mit dem Einstellstift kann die Verriegelung und Befestigung der Platine vorgenommen werden.

Bei einer vorteilhaften beispielhaften Ausführungsform ist vorgesehen, dass die vorstehend bezeichnete Befestigungsabdeckung transparent ausgebildet ist. Die transparente Befestigungsabdeckung ist für bestimmte Gegebenheiten geeignet, beispielsweise für lichtemittierende Komponenten an der Platine.

Erfindungsgemäß weist die Betätigungsvorrichtung für einen Drehschalter mit automatischer Rücksetzung einen Griff, eine Montageachse und zwei bogenförmige Federn auf, wobei innerhalb der vorstehend bezeichneten Montageachse ein Innenraum vorgesehen ist, in dem eine Platine aufgenommen ist, wobei an der vorstehend bezeichneten Platine zwei Hall-Komponenten vorgesehen sind, wobei ein Ende des vorstehend bezeichneten Griffs eine Durchgangsöffnung zum Umgreifen der Montageachse aufweist, wobei der vorstehend bezeichnete Griff in Umfangsrichtung um die vorstehend bezeichnete Montageachse drehbar ist, wobei zwischen dem vorstehend bezeichneten Griff und der vorstehend bezeichneten Montageachse zwei in Umfangsrichtung vorgesehene bogenförmige Rillen angeordnet sind, wobei die beiden vorstehend bezeichneten bogenförmigen Federn jeweils in den beiden vorstehend bezeichneten bogenförmigen Rillen montiert sind, wobei die vorstehend bezeichneten bogenförmigen Federn zwischen der vorstehend bezeichneten Montageachse und dem Griff eingespannt sind, wobei an dem vorstehend bezeichneten Griff ein Schlitz vorgesehen ist, wobei innerhalb des vorstehend bezeichneten Schlitzes eine magnetische Komponente zum Auslösen der vorstehend bezeichneten Hall-Komponenten vorgesehen ist, wobei der vorstehend bezeichnete Griff bei einer Vorwärtsdrehung um die vorstehend bezeichnete Montageachse die eine bogenförmige Feder komprimiert und die magnetische Komponente zum Auslösen der einen Hall-Komponente mitbewegt, während der vorstehend bezeichnete Griff bei einer Rückwärtsdrehung um die vorstehend bezeichnete Montageachse die andere bogenförmige Feder komprimiert und die magnetische Komponente zum Auslösen der anderen Hall-Komponente mitbewegt. Konkret ist vorgesehen, dass der vorstehend bezeichnete Griff im Verlauf der Vorwärtsdrehung aus der Anfangsposition die eine bogenförmige Feder allmählich komprimiert, so dass die magnetische Komponente nach der synchronen Vorwärtsdrehung mit dem Griff die eine Hall-Komponente auslöst. Nach dem Loslassen des vorstehend bezeichneten Griffs erfolgt gleichzeitig mit der automatischen Entspannung der komprimierten bogenförmigen Feder ein Drücken des vorstehend bezeichneten Griffs zur Rückwärtsdrehung in die Anfangsposition. Im Verlauf der Rückwärtsdrehung des vorstehend bezeichneten Griffs aus der Anfangsposition wird die andere Feder bogenförmige allmählich komprimiert wird, so dass die magnetische Komponente nach der synchronen Rückwärtsdrehung mit dem Griff die andere Hall-Komponente auslöst. Nach dem Loslassen des vorstehend bezeichneten Griffs erfolgt gleichzeitig mit der automatischen Entspannung der komprimierten bogenförmigen Feder ein Drücken des vorstehend bezeichneten Griffs zur Vorwärtsdrehung in die Anfangsposition.

Durch das Zusammenwirken von Federn und bogenförmigen Rillen kann abgesehen von der automatischen Rücksetzung des Drehschalters eine Anwendung der Betätigungsvorrichtung für einen Drehschalter mit automatischer Rücksetzung bei der Aktivierung von Hall-Komponenten erfolgen sowie die beim Stand der Technik auftretenden Störungen der Hall-Komponenten durch den für die Realisierung der Rücksetzung vorgesehenen Magneten vermieden werden.

### Figurenbeschreibung

Im Folgenden wird die Erfindung anhand von Ausführungsbeispielen im Zusammenhang mit den anhängenden Figuren beschrieben.
Figur 1 zeigt eine dreidimensionale Explosionsdarstellung der Betätigungsvorrichtung für einen Drehschalter mit automatischer Rücksetzung.
Figur 2 zeigt eine dreidimensionale Darstellung der Montageachse.
Figur 3 zeigt eine dreidimensionale Darstellung der Betätigungsvorrichtung für einen Drehschalter mit automatischer Rücksetzung aus Figur 1.
Figur 4 zeigt eine axiale Schnittansicht der Betätigungsvorrichtung für einen Drehschalter mit automatischer Rücksetzung aus Figur 1.
Figur 5 zeigt eine radiale Schnittansicht der Betätigungsvorrichtung für einen Drehschalter mit automatischer Rücksetzung aus Figur 1.
Figur 6 zeigt eine Darstellung der Betätigung des Griffs der Betätigungsvorrichtung für einen Drehschalter mit automatischer Rücksetzung aus Figur 1 bei Drehung gegen den Uhrzeigersinn.
Figur 7 zeigt eine Darstellung der Betätigung des Griffs der Betätigungsvorrichtung für einen Drehschalter mit automatischer Rücksetzung aus Figur 1 bei Drehung im Uhrzeigersinn.

### Ausführungsbeispiel

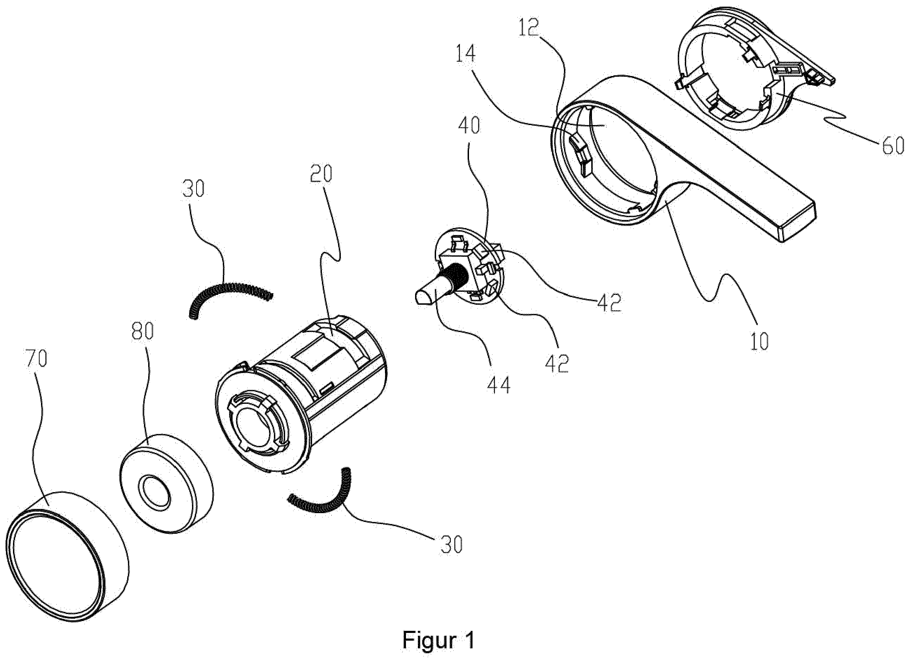

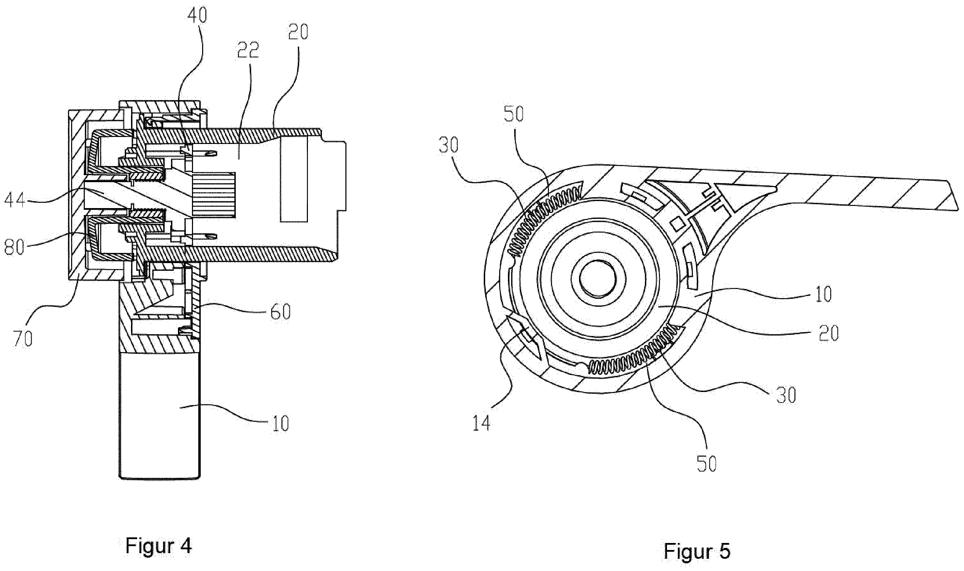

Die in den Figuren 1 bis 7 gezeigte Betätigungsvorrichtung für einen Drehschalter mit automatischer Rücksetzung umfasst einen Griff 10, eine Montageachse 20 und zwei bogenförmige Federn 30, wobei innerhalb der vorstehend bezeichneten Montageachse 20 ein Innenraum 22 vorgesehen ist, in dem eine Platine 40 aufgenommen ist, wobei an der vorstehend bezeichneten Platine 40 zwei Hall-Komponenten 42 vorgesehen sind, wobei ein Ende des vorstehend bezeichneten Griffs 10 eine Durchgangsöffnung 12 zum Umgreifen der Montageachse aufweist, wobei der vorstehend bezeichnete Griff 10 in Umfangsrichtung um die vorstehend bezeichnete Montageachse 20 drehbar ist, und wobei zwischen dem vorstehend bezeichneten Griff 10 und der vorstehend bezeichneten Montageachse 20 zwei in Umfangsrichtung verlaufende bogenförmige Rillen 50 angeordnet sind.

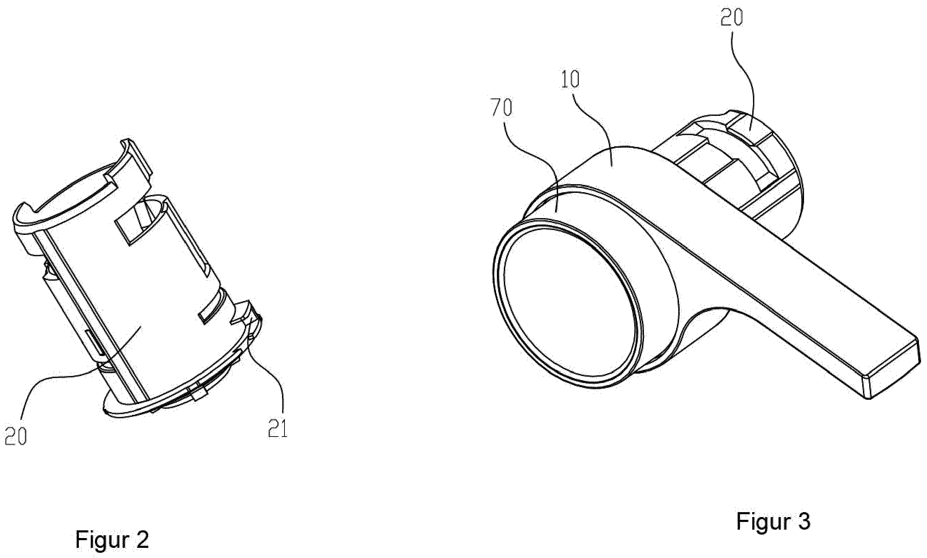

Bei dem Ausführungsbeispiel ist an der Innenfläche der Durchgangsöffnung 12 und an der äußeren Umfangsfläche der Montageachse 20 jeweils eine Rille vorgesehen, wobei die beiden Rillen die bogenförmigen Rillen 50 bilden. Weil der Griff drehbar ist, versteht es sich, dass die Länge der bogenförmigen Rille 50 im Zuge der Drehung des Griffs eine Veränderung erfährt. In Figur 2 ist eine an der Montageachse 20 vorgesehene Rille 21 gezeigt. Die beiden vorstehend bezeichneten bogenförmigen Federn 30 sind jeweils in den beiden vorstehend bezeichneten bogenförmigen Rillen 50 montiert, wobei die vorstehend bezeichneten bogenförmigen Federn 30 zwischen der vorstehend bezeichnete Montageachse 20 und dem Griff 10 eingespannt sind, so dass im Falle einer durch die Drehung des Griffs bewirkten Verkürzung der bogenförmigen Rillen 50 die vorstehend bezeichneten bogenförmigen Federn 30 Druck erfahren. An dem vorstehend bezeichneten Griff 10 ist außerdem ein Schlitz ausgebildet, wobei innerhalb des vorstehend bezeichneten Schlitzes eine magnetische Komponente zum Auslösen der vorstehend bezeichneten Hall-Komponenten 42 angeordnet ist. Es versteht sich, dass eine Drehung des Griffs 10 die magnetische Komponente zur gemeinsamen Bewegung mitbewegt, so dass die magnetische Komponente, wenn es sich nahe an den Hall-Komponenten 42 befindet, die Hall-Komponenten 42 auslöst. Zum konkreten Prinzip wird auf den Stand der Technik verwiesen.

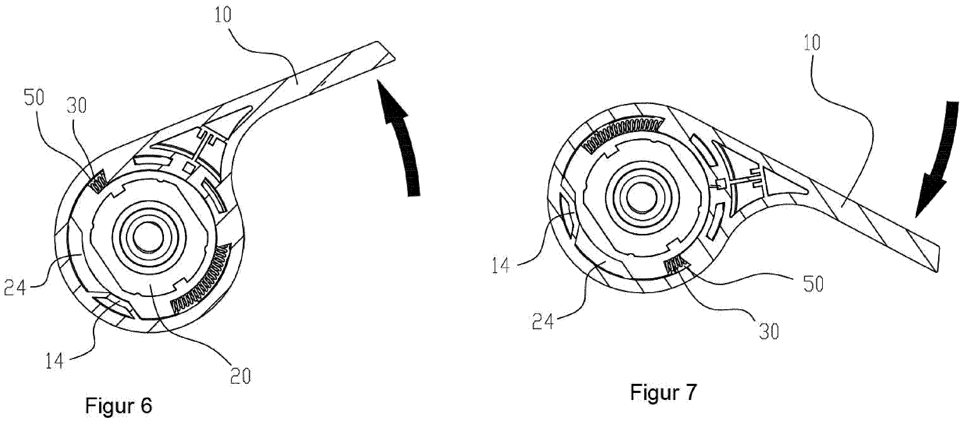

Somit komprimiert, wie in Figur 6 gezeigt, der vorstehend bezeichnete Griff 10 bei einer Vorwärtsdrehung um die vorstehend bezeichnete Montageachse 20 die eine bogenförmige Feder 30 und bewegt die magnetische Komponente zum Auslösen der einen Hall-Komponente 42 mit.

Konkret ist vorgesehen, dass der vorstehend bezeichnete Griff 10 im Verlauf der Vorwärtsdrehung aus der Anfangsposition die eine bogenförmige Feder allmählich komprimiert, so dass die magnetische Komponente nach der synchronen Vorwärtsdrehung mit dem Griff die eine Hall-Komponente auslöst. Nach dem Loslassen des vorstehend bezeichneten Griffs erfolgt gleichzeitig mit der automatischen Entspannung der komprimierten bogenförmigen Feder ein Drücken des vorstehend bezeichneten Griffs zur Rückwärtsdrehung in die Anfangsposition.

Somit komprimiert, wie in Figur 7 gezeigt, der vorstehend bezeichnete Griff 10 bei einer Rückwärtsdrehung um die vorstehend bezeichnete Montageachse 20 die andere bogenförmige Feder 30 und bewegt die magnetische Komponente zum Auslösen der anderen Hall-Komponente 42 mit.

Konkret ist vorgesehen, dass der vorstehend bezeichnete Griff im Verlauf der Rückwärtsdrehung aus der Anfangsposition die andere bogenförmige Feder allmählich komprimiert, so dass die magnetische Komponente nach der synchronen Rückwärtsdrehung mit dem Griff die andere Hall-Komponente auslöst. Nach dem Loslassen des vorstehend bezeichneten Griffs erfolgt gleichzeitig mit der automatischen Entspannung der komprimierten bogenförmigen Feder ein Drücken des vorstehend bezeichneten Griffs zur Vorwärtsdrehung in die Anfangsposition.

Vorteilhaft ist vorgesehen, dass sich die beiden vorstehend bezeichneten bogenförmigen Rillen 50 in einem Radialschnitt auf demselben Umfang befinden.

Vorteilhaft ist vorgesehen, dass zwischen dem vorstehend bezeichneten Griff 10 und der vorstehend bezeichneten Montageachse 20 eine Begrenzungseinrichtung vorgesehen ist, welche die Vorwärtsdrehung und die Rückwärtsdrehung des vorstehend bezeichneten Griffs begrenzt. Bei dem vorliegenden Ausführungsbeispiel umfasst die vorstehend bezeichnete Begrenzungseinrichtung einen an dem vorstehend bezeichneten Griff 10 vorgesehenen Vorsprung 14 sowie eine an der vorstehend bezeichneten Montageachse 20 vorgesehene Begrenzungsaussparung 24.

Vorteilhaft ist vorgesehen, dass außerdem eine Positionierungsabdeckung 60 umfasst ist, wobei die vorstehend bezeichnete Positionierungsabdeckung 60 die vorstehend bezeichnete Montageachse 10 umgreift, und wobei die vorstehend bezeichnete Positionierungsabdeckung 60 an einem axialen Ende des vorstehend bezeichneten Griffs 10 angeordnet und durch Klemmen mit dem vorstehend bezeichneten Griff verbunden ist. Eine derartige Positionierungsabdeckung 60 kann sich gemeinsam mit dem Griff 10 in Umfangsrichtung drehen.

Vorteilhaft ist vorgesehen, dass die vorstehend bezeichnete Positionierungsabdeckung 60 mit der vorstehend bezeichneten Montageachse 20 derart in axialer Klemmverbindung steht, dass der Griff in axialer Richtung festgelegt ist.

Vorteilhaft ist vorgesehen, dass außerdem eine drehbare Abdeckung 70 umfasst ist, wobei die vorstehend bezeichnete drehbare Abdeckung 70 und die vorstehend bezeichnete Positionierungsabdeckung 60 jeweils an einem Ende des vorstehend bezeichneten Griffs 10 angeordnet ist, wobei die vorstehend bezeichnete drehbare Abdeckung 70 axial das Ende der vorstehend bezeichneten Montageachse 20 abdeckt und sich bis zur Stirnfläche des anderen Ende des vorstehend bezeichneten Griffs erstreckt.

Vorteilhaft ist vorgesehen, dass mittig der vorstehend bezeichneten Platine 40 ein sich axial zu der vorstehend bezeichneten drehbaren Abdeckung 70 hin erstreckender Einstellstift 44 vorgesehen ist, wobei der vorstehend bezeichnete Einstellstift 44 durch Stecken mit der vorstehend bezeichneten drehbaren Abdeckung 70 verbunden ist, wobei die vorstehend bezeichnete drehbare Abdeckung 70 in Umfangsrichtung mit dem vorstehend bezeichneten Einstellstift 44 in Klemmverbindung steht, und wobei der vorstehend bezeichnete Einstellstift 44 bezogen auf die vorstehend bezeichnete Platine 40 drehbar ist. Somit kann durch eine Betätigung der vorstehend bezeichneten drehbaren Abdeckung der vorstehend bezeichnete Einstellstift 44 mitgedreht werden.

Vorteilhaft ist vorgesehen, dass außerdem eine Befestigungsabdeckung 80 umfasst ist, wobei die vorstehend bezeichnete Platine 40 innerhalb der vorstehend bezeichnete Montageachse 20 angeordnet ist, wobei die vorstehend bezeichnete Befestigungsabdeckung 80 innerhalb der vorstehend bezeichneten drehbaren Abdeckung 70 aufgenommen und außerhalb der vorstehend bezeichneten Montageachse 20 angeordnet ist, wobei sich der vorstehend bezeichnete Einstellstift 44 axial aus der vorstehend bezeichneten Montageachse 20 herauserstreckt, und wobei die vorstehend bezeichnete Befestigungsabdeckung 80 mit dem vorstehend bezeichneten Einstellstift 44 derart in Gewindeeingriff steht, dass die Platine an der Montageachse befestigt ist. Vorteilhaft ist vorgesehen, dass die vorstehend bezeichnete Befestigungsabdeckung 80 eine transparent ist.

Es versteht sich, dass bei dem vorliegenden Ausführungsbeispiel die Verwendung bogenförmiger Federn 50 eine bessere Abstimmung auf die bogenförmigen Rillen 50 ermöglicht, wobei allerdings auch die Verwendung gerader Federn möglich ist. Die Form bogenförmiger Rillen 50 ermöglicht ebenso eine Fixierung gerader Federn. Außerdem wurde zwar in dem vorliegenden Ausführungsbeispiel beschrieben, dass die Platine 40 innerhalb der Montageachse 20 vorgesehen ist und dass an der Platine zwei Hall-Komponenten 42 vorgesehen sind. Allerdings kann die Vorwärtsdrehung oder Rückwärtsdrehung des Griffs auch eine gekoppelte Bewegung weiterer Teile realisieren, beispielsweise Mikroschalter oder Optokoppler. Dies bedeutet mit anderen Worten, dass die Frage, durch welches Teil nach der Drehung des Griffs 10 die Funktion welchen Teils realisiert wird, nicht das durch die vorliegende Anmeldung zu lösende technische Problem darstellt. Es reicht aus, dass nach der Betätigung des Griffs zur Vorwärtsdrehung und Rückwärtsdrehung der Griff unter Antrieb der Federn automatisch in die jeweilige Gegenrichtung dreht und eine Rücksetzung in die Anfangsposition erfolgt.

## Patentansprüche

1. Betätigungsvorrichtung für einen Drehschalter mit automatischer Rücksetzung, umfassend einen Griff (10), wobei die Betätigungsvorrichtung eine Montageachse (20) und zwei Federn (30) aufweist, wobei innerhalb der vorstehend bezeichneten Montageachse (20) ein Innenraum (22) vorgesehen ist, in dem eine Platine (40) aufgenommen ist, wobei an der vorstehend bezeichneten Platine (40) zwei Hall-Komponenten (42) vorgesehen sind, wobei ein Ende des vorstehend bezeichneten Griffs eine Durchgangsöffnung (12) zum Umgreifen der Montageachse (20) aufweist, wobei der vorstehend bezeichnete Griff (10) in Umfangsrichtung um die vorstehend bezeichnete Montageachse (20) drehbar ist, wobei zwischen dem vorstehend bezeichneten Griff (10) und der vorstehend bezeichneten Montageachse (20) zwei in Umfangsrichtung vorgesehene bogenförmige Rillen (50) angeordnet sind, wobei die beiden vorstehend bezeichneten Federn (30) jeweils in den beiden vorstehend bezeichneten bogenförmigen Rillen (50) montiert sind, wobei die vorstehend bezeichneten Federn (30) zwischen der vorstehend bezeichneten Montageachse (20) und dem Griff (10) eingespannt sind, wobei an dem vorstehend bezeichneten Griff (10) ein Schlitz vorgesehen ist, wobei innerhalb des vorstehend bezeichneten Schlitzes eine magnetische Komponente zum Auslösen der vorstehend bezeichneten Hall-Komponenten (42) vorgesehen ist, wobei der vorstehend bezeichnete Griff (10) bei einer Vorwärtsdrehung um die vorstehend bezeichnete Montageachse (20) die eine Feder (30) komprimiert und die magnetische Komponente zum Auslösen der einen Hall-Komponente (42) mitbewegt, während der vorstehend bezeichnete Griff (10) bei einer Rückwärtsdrehung um die vorstehend bezeichnete Montageachse (20) die andere Feder (30) komprimiert und die magnetische Komponente zum Auslösen der anderen Hall-Komponente (42) mitbewegt.

2. Betätigungsvorrichtung für einen Drehschalter mit automatischer Rücksetzung nach Anspruch 1, **dadurch gekennzeichnet, dass** sich die beiden vorstehend bezeichneten bogenförmigen Rillen (50) in einem Radialschnitt auf demselben Umfang befinden, wobei es sich bei den vorstehend bezeichneten Federn (30) um gebogene Federn oder um gerade Federn handelt.

3. Betätigungsvorrichtung für einen Drehschalter mit automatischer Rücksetzung nach Anspruch 1, **dadurch gekennzeichnet, dass** zwischen dem vorstehend bezeichneten Griff (10) und der vorstehend bezeichneten Montageachse (20) eine Begrenzungseinrichtung vorgesehen ist, welche die Vorwärtsdrehung und die Rückwärtsdrehung des vorstehend bezeichneten Griffs (10) begrenzt.

4. Betätigungsvorrichtung für einen Drehschalter mit automatischer Rücksetzung nach Anspruch 3, **dadurch gekennzeichnet, dass** die vorstehend bezeichnete Begrenzungseinrichtung einen an dem vorstehend bezeichneten Griff (10) vorgesehenen Vorsprung (14) sowie eine an der vorstehend bezeichneten Montageachse (20) vorgesehene Begrenzungsaussparung (24) umfasst.

5. Betätigungsvorrichtung für einen Drehschalter mit automatischer Rücksetzung nach Anspruch 1, **dadurch gekennzeichnet, dass** eine Positionierungsabdeckung (60) umfasst ist, wobei die vorstehend bezeichnete Positionierungsabdeckung (60) die vorstehend bezeichnete Montageachse (20) umgreift, und wobei die vorstehend bezeichnete Positionierungsabdeckung (60) an einem axialen Ende des vorstehend bezeichneten Griffs (10) angeordnet und durch Klemmen mit dem vorstehend bezeichneten Griff (10) verbunden ist.

6. Betätigungsvorrichtung für einen Drehschalter mit automatischer Rücksetzung nach Anspruch 5, **dadurch gekennzeichnet, dass** die vorstehend bezeichnete Positionierungsabdeckung (60) mit der vorstehend bezeichneten Montageachse (20) in axialer Klemmverbindung steht.

7. Betätigungsvorrichtung für einen Drehschalter mit automatischer Rücksetzung nach Anspruch 6, **dadurch gekennzeichnet, dass** eine drehbare Abdeckung (70) umfasst ist, wobei die vorstehend bezeichnete drehbare Abdeckung (70) und die vorstehend bezeichnete Positionierungsabdeckung (60) jeweils an einem Ende des vorstehend bezeichneten Griffs (10) angeordnet sind, und wobei die vorstehend bezeichnete drehbare Abdeckung (70) axial das Ende der vorstehend bezeichneten Montageachse (20) abdeckt und sich bis zur Stirnfläche des anderen Endes des vorstehend bezeichneten Griffs (10) erstreckt.

8. Betätigungsvorrichtung für einen Drehschalter mit automatischer Rücksetzung nach Anspruch 7, **dadurch gekennzeichnet, dass** mittig der vorstehend bezeichneten Platine (40) ein sich axial zu der vorstehend bezeichneten drehbaren Abdeckung (70) hin erstreckender Einstellstift (44) vorgesehen ist, wobei der vorstehend bezeichnete Einstellstift (44) durch Stecken mit der vorstehend bezeichneten drehbaren Abdeckung (70) verbunden ist, wobei die vorstehend bezeichnete drehbare Abdeckung (70) in Umfangsrichtung mit dem vorstehend bezeichneten Einstellstift (44) in Klemmverbindung steht, und wobei der vorstehend bezeichnete Einstellstift (44) bezogen auf die vorstehend bezeichnete Platine (40) drehbar ist.

9. Betätigungsvorrichtung für einen Drehschalter mit automatischer Rücksetzung nach Anspruch 8, **dadurch gekennzeichnet, dass** eine Befestigungsabdeckung (80) umfasst ist, wobei die vorstehend bezeichnete Platine (40) innerhalb der vorstehend bezeichnete Montageachse (20) angeordnet ist, wobei die vorstehend bezeichnete Befestigungsabdeckung (80) innerhalb der vorstehend bezeichneten drehbaren Abdeckung (70) aufgenommen und außerhalb der vorstehend bezeichneten Montageachse (20) angeordnet ist, wobei sich der vorstehend bezeichnete Einstellstift (44) axial aus der vorstehend bezeichneten Montageachse (20) herauserstreckt, wobei die vorstehend bezeichnete Befestigungsabdeckung (80) mit dem vorstehend bezeichneten Einstellstift (44) in Gewindeeingriff steht, und wobei die vorstehend bezeichnete Befestigungsabdeckung (80) transparent ist.

## Claims

1. Actuating apparatus for a rotary switch with automatic resetting, comprising a handle (10), wherein the actuating apparatus has a mounting shaft (20) and two springs (30), wherein, within the mounting shaft (20) referred to above, provision is made for an interior space (22) in which a circuit board (40) is received, wherein, on the circuit board (40) referred to above, provision is made for two Hall components (42), wherein one end of the handle referred to above has a passage opening (12) for engagement around the mounting shaft (20), wherein the handle (10) referred to above is rotatable in a circumferential direction around the mounting shaft (20) referred to above, wherein two arcuate grooves (50) provided in the circumferential direction are arranged between the handle (10) referred to above and the mounting shaft (20) referred to above, wherein the two springs (30) referred to above are respectively fitted into the two arcuate grooves (50) referred to above, wherein the springs (30) referred to above are clamped between the mounting shaft (20) referred to above and the handle (10), wherein provision is made for a slot in the handle (10) referred to above, wherein, within the slot referred to above, provision is made for a magnetic component for triggering the Hall components (42) referred to above, wherein, during a forward rotation around the mounting shaft (20) referred to above, the handle (10) referred to above compresses the one spring (30) and carries along the magnetic component for triggering the one Hall component (42), while, during a backward rotation around the mounting shaft (20) referred to above, the handle (10) referred to above compresses the other spring (30) and carries along the magnetic component for triggering the other Hall component (42).

2. Actuating apparatus for a rotary switch with automatic resetting according to Claim 1, **characterized in that**, in a radial section, the two arcuate grooves (50) referred to above are situated on the same circumference, wherein the springs (30) referred to above are bent springs or straight springs.

3. Actuating apparatus for a rotary switch with automatic resetting according to Claim 1, **characterized in that**, between the handle (10) referred to above and the mounting shaft (20) referred to above, provision is made for a limiting device which limits the forward rotation and the backward rotation of the handle (10) referred to above.

4. Actuating apparatus for a rotary switch with automatic resetting according to Claim 3, **characterized in that** the limiting device referred to above comprises a projection (14), which is provided on the handle (10) referred to above, and a limitation cutout (24), which is provided in the mounting shaft (20) referred to above.

5. Actuating apparatus for a rotary switch with automatic resetting according to Claim 1, **characterized in that** a positioning cover (60) is comprised, wherein the positioning cover (60) referred to above engages around the mounting shaft (20) referred to above, and wherein the positioning cover (60) referred to above is arranged on an axial end of the handle (10) referred to above and is connected to the handle (10) referred to above by way of clamping.

6. Actuating apparatus for a rotary switch with automatic resetting according to Claim 5, **characterized in that** the positioning cover (60) referred to above is in axial clamping connection with the mounting shaft (20) referred to above.

7. Actuating apparatus for a rotary switch with automatic resetting according to Claim 6, **characterized in that** a rotatable cover (70) is comprised, wherein the rotatable cover (70) referred to above and the positioning cover (60) referred to above are arranged on respective ends of the handle (10) referred to above, and wherein the rotatable cover (70) referred to above axially covers the end of the mounting shaft (20) referred to above and extends as far as the end face of the other end of the handle (10) referred to above.

8. Actuating apparatus for a rotary switch with automatic resetting according to Claim 7, **characterized in that**, centrally in the circuit board (40) referred to above, provision is made for a setting pin (44) which extends axially towards the rotatable cover (70) referred to above, wherein the setting pin (44) referred to above is connected by way of plugging to the rotatable cover (70) referred to above, wherein the rotatable cover (70) referred to above is in clamping connection with the setting pin (44) referred to above in the circumferential direction, and wherein the setting pin (44) referred to above is rotatable in relation to the circuit board (40) referred to above.

9. Actuating apparatus for a rotary switch with automatic resetting according to Claim 8, **characterized in that** a fastening cover (80) is comprised, wherein the circuit board (40) referred to above is arranged within the mounting shaft (20) referred to above, wherein the fastening cover (80) referred to above is received within the rotatable cover (70) referred to above and is arranged outside the mounting shaft (20) referred to above, wherein the setting pin (44) referred to above extends axially out of the mounting shaft (20) referred to above, wherein the fastening cover (80) referred to above is in threaded engagement with the setting pin (44) referred to above, and wherein the fastening cover (80) referred to above is transparent.

## Revendications

1. Dispositif d'actionnement pour un interrupteur rotatif à réinitialisation automatique, comprenant une poignée (10), le dispositif d'actionnement présentant un axe de montage (20) et deux ressorts (30), un espace intérieur (22) étant prévu à l'intérieur de l'axe de montage (20) susmentionné, dans lequel est logée une platine (40), deux composants Hall (42) étant prévus sur la platine (40) susmentionnée, une extrémité de la poignée susmentionnée présentant une ouverture de passage (12) pour entourer l'axe de montage (20), la poignée (10) susmentionnée étant rotative dans la direction circonférentielle autour de l'axe de montage (20) susmentionné, deux rainures arquées (50) prévues dans la direction circonférentielle étant agencées entre la poignée (10) susmentionnée et l'axe de montage (20) susmentionné, les deux ressorts (30) susmentionnés étant montés respectivement dans les deux rainures arquées (50) susmentionnées, les ressorts (30) susmentionnés étant tendus entre l'axe de montage (20) susmentionné et la poignée (10), une fente étant prévue sur la poignée (10) susmentionnée, un composant magnétique étant prévu à l'intérieur de la fente susmentionnée pour déclencher les composants Hall (42) susmentionnés, la poignée (10) susmentionnée, lors d'une rotation vers l'avant autour de l'axe de montage (20) susmentionné, comprimant un ressort (30) et entraînant le composant magnétique pour déclencher un composant Hall (42), tandis que la poignée (10) susmentionnée, lors d'une rotation vers l'arrière autour de l'axe de montage (20) susmentionné, comprime l'autre ressort (30) et entraîne le composant magnétique pour déclencher l'autre composant Hall (42).

2. Dispositif d'actionnement pour un interrupteur rotatif à réinitialisation automatique selon la revendication 1, **caractérisé en ce que** les deux rainures arquées (50) susmentionnées se trouvent dans une coupe radiale sur la même circonférence, les ressorts (30) susmentionnés consistant en des ressorts courbes ou des ressorts droits.

3. Dispositif d'actionnement pour un interrupteur rotatif à réinitialisation automatique selon la revendication 1, **caractérisé en ce qu'**un appareil de limitation est prévu entre la poignée (10) susmentionnée et l'axe de montage (20) susmentionné, lequel limite la rotation vers l'avant et la rotation vers l'arrière de la poignée (10) susmentionnée.

4. Dispositif d'actionnement pour un interrupteur rotatif à réinitialisation automatique selon la revendication 3, **caractérisé en ce que** l'appareil de limitation susmentionné comprend une saillie (14) prévue sur la poignée (10) susmentionnée et un évidement de limitation (24) prévu sur l'axe de montage (20) susmentionné.

5. Dispositif d'actionnement pour un interrupteur rotatif à réinitialisation automatique selon la revendication 1, **caractérisé en ce qu'**il comprend un couvercle de positionnement (60), le couvercle de positionnement (60) susmentionné entourant l'axe de montage (20) susmentionné, et le couvercle de positionnement (60) susmentionné étant agencé à une extrémité axiale de la poignée (10) susmentionnée et étant relié par serrage à la poignée (10) susmentionnée.

6. Dispositif d'actionnement pour un interrupteur rotatif à réinitialisation automatique selon la revendication 5, **caractérisé en ce que** le couvercle de positionnement (60) susmentionné est en liaison axiale par serrage avec l'axe de montage (20) susmentionné.

7. Dispositif d'actionnement pour un interrupteur rotatif à réinitialisation automatique selon la revendication 6, **caractérisé en ce qu'**il comprend un couvercle rotatif (70), le couvercle rotatif (70) susmentionné et le couvercle de positionnement (60) susmentionnés étant agencés chacun à une extrémité de la poignée (10) susmentionnée, et le couvercle rotatif (70) susmentionné recouvrant axialement l'extrémité de l'axe de montage (20) susmentionné et s'étendant jusqu'à la surface frontale de l'autre extrémité de la poignée (10) susmentionnée.

8. Dispositif d'actionnement pour un interrupteur rotatif à réinitialisation automatique selon la revendication 7, **caractérisé en ce qu'**il est prévu, au centre de la platine (40) susmentionnée, une broche de réglage (44) s'étendant axialement vers le couvercle rotatif (70) susmentionné, la broche de réglage (44) susmentionnée étant reliée par enfichage au couvercle rotatif (70) susmentionné, le couvercle rotatif (70) susmentionné étant en liaison de serrage dans la direction circonférentielle avec la broche de réglage (44) susmentionnée, et la broche de réglage (44) susmentionnée étant rotative par rapport à la platine (40) susmentionnée.

9. Dispositif d'actionnement pour un interrupteur rotatif à réinitialisation automatique selon la revendication 8, **caractérisé en ce qu'**il comprend un couvercle de fixation (80), la platine (40) susmentionnée étant agencée à l'intérieur de l'axe de montage (20) susmentionné, le couvercle de fixation (80) susmentionné susmentionné et étant agencé à l'extérieur de l'axe de montage (20) susmentionné, la tige de réglage (44) susmentionnée s'étendant axialement hors de l'axe de montage (20) susmentionné, le couvercle de fixation (80) susmentionné étant en prise par vissage avec la tige de réglage (44) susmentionnée, et le couvercle de fixation (80) susmentionné étant transparent.
